# EUROPEAN PATENT APPLICATION

(11) **EP 4 852 670 A1**
(43) Date of publication of application: **09.12.2026**
(21) Application number: 26182351.2
(22) Date of filing: 01.06.2026
(51) Int. Cl.: H10F 77/20, H10F 10/14, H10F 10/165, H10F 77/70

(54) **METAL-SEMICONDUCTOR CONTACT STRUCTURE AND MANUFACTURING METHOD THEREFOR, SOLAR CELL, AND PHOTOVOLTAIC MODULE**

(30) Priority: 05.06.2025 CN 202510748903
(71) Applicant: Tongwei Solar (Chengdu) Co., Ltd., Chengdu, Sichuan 610299 (CN)
(72) Inventor: YU, Bin, Chengdu, 610299 (CN); MENG, Xiajie, Chengdu, 610299 (CN)
(74) Representative: Murgitroyd & Company

(57) **Abstract**

Disclosed are a metal-semiconductor contact structure and a manufacturing method therefor, a solar cell, and a photovoltaic module. The metal-semiconductor contact structure includes: a doped semiconductor layer with a surface of a pyramid structure; and a metal electrode in contact with the doped semiconductor layer. A first contact region is provided at a contact interface between the doped semiconductor layer and the metal electrode, and a plurality of first conductive microstructures are provided in the first contact region. Particles forming the plurality of first conductive microstructures are eutectic particles composed of a metal element and a semiconductor element. From an apex of the pyramid structure toward a base of the pyramid structure, a distribution density of the plurality of first conductive microstructures on the pyramid structure exhibits a decreasing trend.

## Description

### TECHNICAL FIELD

The present disclosure relates to the field of solar cell technologies, and in particular, to a metal-semiconductor contact structure and a manufacturing method therefor, a solar cell, and a photovoltaic module.

### BACKGROUND

In the field of solar cells, a metal-semiconductor contact structure has a significant impact on the photoelectric performance of solar cells. However, when the metal-semiconductor contact structure includes a doped semiconductor layer with a pyramid-shaped surface, the structural morphology at a contact interface between a metal electrode and a pyramid structure is not ideal, which can easily lead to issues such as metal-induced recombination loss and surface recombination loss. It is evident that the structural morphology at the contact interface of such metal-semiconductor contact structures still requires further optimization to more effectively improve the contact performance between the metal electrode and the doped semiconductor layer, thereby enhancing the photoelectric conversion efficiency of solar cells.

### SUMMARY

To address the above technical issues, the present disclosure discloses a metal-semiconductor contact structure and a manufacturing method therefor, a solar cell, and a photovoltaic module, aiming to more effectively improve the contact performance of the metal-semiconductor contact structure and thereby enhance the photoelectric conversion efficiency of solar cells.

In a first aspect, the present disclosure provides a metal-semiconductor contact structure, including:
a doped semiconductor layer, a surface of the doped semiconductor layer including a surface of at least one pyramid structure;
a metal electrode in contact with the doped semiconductor layer; and
a first contact region provided at a contact interface between the doped semiconductor layer and the metal electrode, a plurality of first conductive microstructures being provided in the first contact region;
where the plurality of first conductive microstructures are disposed between the metal electrode and the pyramid structure, and are disposed on a smooth surface of the pyramid structure; particles forming the plurality of first conductive microstructures are eutectic particles composed of a metal element and a semiconductor element, the metal element is the same as a metal element in the metal electrode, and the semiconductor element is the same as a main semiconductor element in the doped semiconductor layer;
from an apex of the pyramid structure toward a base of the pyramid structure, a distribution density of the plurality of first conductive microstructures on the pyramid structure exhibits a decreasing trend.

Further, a particle size of the eutectic particles ranges from 10 nm to 200 nm; and/or,
a quantity of the eutectic particles ranges from 100 to 1500 in any 10 µm×10 µm region of the first contact region; and/or,
the plurality of first conductive microstructures are spaced apart and dispersed on the surface of the pyramid structure; and/or,
at least part of the plurality of first conductive microstructures are distributed in a conical shape on the pyramid structure.

Further, a side length of the base of the pyramid structure ranges from 0.35 µm to 2.5 µm; and/or,
a diagonal length of the base of the pyramid structure ranges from 0.5 µm to 3.5 µm

Further, the at least one pyramid structure includes: a plurality of first-type pyramid structures and a plurality of second-type pyramid structures distributed among the plurality of first-type pyramid structures;
a diagonal length of a base of each of the plurality of first-type pyramid structures ranges from 1.5 µm to 3.5 µm, and a diagonal length of a base of each of the plurality of the second-type pyramid structures ranges from 0.5 µm to 1.5 µm.

Further, the plurality of first conductive microstructures are distributed in a first distribution region and a second distribution region on a surface of each of the plurality of first-type pyramid structures; in the first distribution region, a distribution density of the first conductive microstructures ranges from 100 pcs/µm² to 400 pcs/µm², and in the second distribution region, a distribution density of the first conductive microstructures ranges from 20 pcs/µm² to 100 pcs/µm², and the distribution of the first conductive microstructures is denser in the first distribution region than in the second distribution region;
where a lateral side length of the pyramid structure is L, a region of the surface of the pyramid structure with a radius less than or equal to R centered on the apex of the pyramid structure is the first distribution region, a region of the surface of the pyramid structure outside the first distribution region is the second distribution region, and R/L ≤ 2:3; and
the distribution density of the first conductive microstructures on a surface of each of the plurality of second-type pyramid structures ranges from 30 pcs/µm² to 100 pcs/µm².

Further, a second contact region is further provided at the contact interface between the doped semiconductor layer and the metal electrode, the second contact region is located at an edge of the first contact region, and a plurality of second conductive microstructures are provided in the second contact region; and
the second conductive microstructures are metal elemental particles embedded in a glass phase of the metal electrode, and a metal element of the metal elemental particles is the same as the metal element in the metal electrode.

Further, in a preset region of the contact interface, an area ratio of the second contact region to the preset region ranges from 1:5 to 1:3, the preset region is an area of any preset width × preset length, centered on a center line of a width of the metal electrode, the preset width is perpendicular to a width direction of the metal electrode, the preset width is less than or equal to 23 µm, the preset length is parallel to the width direction of the metal electrode, and the preset length is less than or equal to 16 µm.

Further, the doped semiconductor layer includes at least one of a doped amorphous silicon layer, a doped polycrystalline silicon layer, a doped microcrystalline silicon layer, and a doped crystalline silicon layer; and/or,
a doping element in the doped semiconductor layer includes at least one of an N-type conductive element or a P-type conductive element; and/or,
the metal element includes at least one of silver, lead, copper, aluminum, nickel, cadmium, or bismuth.

In a second aspect, embodiments of the present disclosure provide a solar cell, including a silicon substrate and a metal-semiconductor contact structure located on the silicon substrate, where the metal-semiconductor contact structure includes:
a doped semiconductor layer, disposed on a surface of the silicon substrate, a surface, facing away from the silicon substrate, of the doped semiconductor layer including a surface of at least one pyramid structure;
a metal electrode, located on a side, facing away from the silicon substrate, of the doped semiconductor layer, and in contact with the doped semiconductor layer; and
a first contact region provided at a contact interface between the doped semiconductor layer and the metal electrode, and a plurality of first conductive microstructures being provided in the first contact region;
where the plurality of first conductive microstructures are disposed between the metal electrode and the pyramid structure, and are disposed on a smooth surface of the pyramid structure; particles forming the plurality of first conductive microstructures are eutectic particles composed of a metal element and a semiconductor element, the metal element is the same as a metal element in the metal electrode, and the semiconductor element is the same as a main semiconductor element in the doped semiconductor layer;
from an apex of the pyramid structure toward a base of the pyramid structure, a distribution density of the plurality of first conductive microstructures on the pyramid structure exhibits a decreasing trend.

Further, the solar cell includes:
a first doped semiconductor layer, a first passivation layer, and a first metal electrode successively provided on a light-receiving surface of the silicon substrate along a direction away from the light-receiving surface of the silicon substrate, the first doped semiconductor layer having a conductivity type opposite to a conductivity type of the silicon substrate, where the first metal electrode passed through the first passivation layer and is in contact with the first doped semiconductor layer, forming the metal-semiconductor contact structure between the first doped semiconductor layer and the first metal electrode; and
a passivation contact structure, a second passivation layer, and a second metal electrode successively provided on a back light surface of the silicon substrate along a direction away from the back light surface of the silicon substrate, where the passivation contact structure includes a dielectric layer disposed adjacent to the silicon substrate and a second doped semiconductor layer disposed on a side, away from the silicon substrate, of the dielectric layer, the second doped semiconductor layer has a same conductivity type as the conductivity type of the silicon substrate, and the second metal electrode passes through the second passivation layer and is in an ohmic contact with the second doped semiconductor layer.

Further, the first doped semiconductor layer is formed by thermal diffusion of a doping element into the silicon substrate, or the first doped semiconductor layer is a doped polycrystalline silicon layer or a doped amorphous silicon layer deposited on the light-receiving surface of the silicon substrate; and/or,
the first passivation layer is one or more layers composed of any combination of an aluminum oxide layer, a silicon oxide layer, a silicon oxynitride layer, and a silicon nitride layer deposited on a PN junction region; and/or,
the dielectric layer includes at least one of a silicon oxide layer, an amorphous silicon layer, a polycrystalline silicon layer, or a silicon carbide layer; and/or,
the second passivation layer is one or more layers composed of any combination of the silicon oxide layer, the silicon oxynitride layer, and the silicon nitride layer deposited on the second doped semiconductor layer.

In a third aspect, embodiments of the present disclosure provide a photovoltaic module, including the solar cell as described in the second aspect, where a plurality of solar cells are connected in series and/or in parallel to form a solar cell string; and
a packaging structure, where the solar cell string is packaged in the packaging structure.

In a fourth aspect, embodiments of the present disclosure provide a manufacturing method for a metal-semiconductor contact structure, the method including:
printing an electrode paste on a doped semiconductor layer; where the electrode paste includes a glass phase material, metal particles, and an organic carrier;
performing staged sintering:
first-stage heating: performing low-temperature drying on the electrode paste to form an electrode precursor on the doped semiconductor layer, where the electrode precursor includes the glass phase material distributed on a surface of a pyramid structure and the metal particles embedded in the glass phase material, and a sintering temperature for the low-temperature drying is lower than a peak sintering temperature of the electrode paste;
second-stage heating: controlling a heating rate in a range from 30°C/s to 45°C/s until the sintering temperature reaches the peak sintering temperature of the electrode paste, so that the surface of the pyramid structure is planarized; and
applying a reverse bias voltage to the electrode precursor while performing laser-induced contact treatment to form a metal electrode and forming eutectic particles on a smooth surface of the pyramid structure;
where conditions for the first-stage heating include: a heating temperature ranging from 250°C to 350°C and a heating time ranging from 5 s to 20 s; and
conditions for the second-stage heating include: a heating temperature ranging from 700°C to 800°C and a heating time ranging from 10 s to 20 s.

Further, a passivation layer is provided on the doped semiconductor layer, and the printing the electrode paste on the doped semiconductor layer includes: printing the electrode paste on the passivation layer;
in the step of first-stage heating, the performing low-temperature drying on the electrode paste to form the electrode precursor on the doped semiconductor layer includes: performing low-temperature drying on the electrode paste to form the electrode precursor on the passivation layer;
in the step of second-stage heating, the controlling the heating rate in the range from 30°C/s to 45°C/s until the sintering temperature reaches the peak sintering temperature of the electrode paste includes: controlling the heating rate in the range from 30°C/s to 45°C/s until the sintering temperature reaches the peak sintering temperature of the electrode paste, so that the electrode precursor only burns through the passivation layer and the surface of the pyramid structure is planarized.

Further, the applying the reverse bias voltage to the electrode precursor while performing the laser-induced contact treatment to form the metal electrode and forming the eutectic particles on the smooth surface of the pyramid structure includes:
after the applying the reverse bias voltage to the electrode precursor while performing the laser-induced contact treatment, performing light injection to form the metal electrode, and forming the eutectic particles on the smooth surface of the pyramid structure.

Compared with the prior art, the present disclosure at least provides the following beneficial effects.

By providing the metal-semiconductor contact structure described above in embodiments of the present disclosure, on one hand, mechanical structural stability of the contact interface between the doped semiconductor layer and the metal electrode may be improved, resulting in more stable and reliable first conductive microstructures and promoting enhancement of carrier transport capability; on the other hand, due to the unique distribution characteristics of the first conductive microstructures on the pyramid structure, issues such as recombination caused by metal recombination and defect damage may be reduced. By comprehensively improving these two aspects, the ohmic contact performance at a pyramid-shaped contact interface between the doped semiconductor layer and the metal electrode is enhanced, thereby more effectively improving the photoelectric conversion efficiency of the solar cell.

### BRIEF DESCRIPTION OF THE DRAWINGS

To more clearly illustrate the technical solutions in the embodiments of the present disclosure, the following briefly introduces accompanying drawings required for describing the embodiments. It is obvious that the accompanying drawings in the following description are only some embodiments of the present disclosure. For those skill in the art, other drawings can be obtained based on these accompanying drawings without creative effort.
FIG. 1 is a schematic structural diagram of a solar cell according to an embodiment of the present disclosure.
FIG. 2 is an enlarged schematic view of a structure at A in FIG. 1.
FIG. 3 is a schematic diagram showing a distribution of first conductive microstructures on a pyramid structure.
FIG. 4(a) is a schematic diagram of a smooth surface of a doped semiconductor layer in a metal-semiconductor contact structure.
FIG. 4(b) is a schematic diagram of a doped semiconductor layer where large pits are formed on side surfaces of pyramids in a metal-semiconductor contact structure.
FIG. 4(c) is a schematic diagram of a doped semiconductor layer where apexes of pyramids are corroded in a metal-semiconductor contact structure.
FIG. 5 is a scanning electron microscope (SEM) image of an untreated bare silicon substrate.
FIG. 6 is a scanning electron microscope (SEM) image of a metal-semiconductor contact structure according to an embodiment of the present disclosure, showing first conductive microstructures distributed on a doped semiconductor layer.
FIG. 7 is a scanning electron microscope (SEM) image of a metal-semiconductor contact structure according to an embodiment of the present disclosure, showing first conductive microstructures distributed on a doped semiconductor layer (at another magnification).
FIG. 8 is a scanning electron microscope (SEM) image of a metal-semiconductor contact structure according to an embodiment of the present disclosure after removing a metal electrode.
FIG. 9 is a scanning electron microscope (SEM) image of a metal-semiconductor contact structure according to another embodiment of the present disclosure, showing first conductive microstructures distributed on a doped semiconductor layer.
FIG. 10 is a flowchart of a manufacturing method for a metal-semiconductor contact structure according to an embodiment of the present disclosure.
FIG. 11 is a flowchart of another manufacturing method for a metal-semiconductor contact structure according to an embodiment of the present disclosure.

Reference Numerals:
1: silicon substrate; 2: doped semiconductor layer; 200: pyramid structure; 201: first-type pyramid structure; 202: second-type pyramid structure; 21: first doped semiconductor layer; 22: second doped semiconductor layer; 3: metal electrode; 31: first metal electrode; 32: second metal electrode; 4: passivation layer; 41: first passivation layer; 42: second passivation layer; 5: dielectric layer; 100: metal-semiconductor contact structure; 100a: first contact region; 101: first conductive microstructure; 211: first distribution region; 212: second distribution region; 100b: second contact region; 102: second conductive microstructure.

### DETAILED DESCRIPTION OF THE EMBODIMENTS

The following clearly describes the technical solutions in embodiments of the present disclosure with reference to the accompanying drawings in embodiments of this disclosure. It is clear that the described embodiments are some but not all of embodiments of the present disclosure. All other embodiments obtained by a person of ordinary skill in the art based on embodiments of the present disclosure without creative efforts shall fall within the protection scope of this disclosure.

In the present disclosure, the orientation or positional relationship indicated by the terms "on", "under", "left", "right", "front", "back", "top", "bottom", "inside", "outside", "middle", "vertical", "horizontal", "transverse", "longitudinal" and the like is based on the orientation or positional relationship shown in the drawings. These terms are mainly intended to better describe the present disclosure and its embodiments and are not intended to limit that the indicated devices, elements or constituents must have a particular orientation, or be constructed and operated in a particular orientation.

Also, in addition to being used to represent an orientation or positional relationship, some of the above terms may also be used to indicate other meanings. For example, the term "on" may also be used in some cases to denote a certain attachment or connection. The specific meanings of these terms in the present disclosure may be understood by those ordinarily skilled in the art as the case may be.

In addition, the terms "installation", "setting", "being provided with", "connecting", "connected", "sleeving" should be understood broadly. For example, the connection may be a fixed connection, a detachable connection or an integrated construction, or may be a mechanical connection or an electrical connection, or may be a direct connection, or may be an indirect connection through an intermediary, or an internal communication between two devices, elements or constituents. The specific meanings of these terms in the present disclosure may be understood by those ordinarily skilled in the art as the case may be.

In addition, the terms "first", "second", etc., are used primarily to distinguish different devices, elements or components (the specific type and construction may be the same or different) and are not used to indicate or imply the relative importance or quantity of the indicated device, element or component. Unless otherwise stated, "plurality" means two or more.

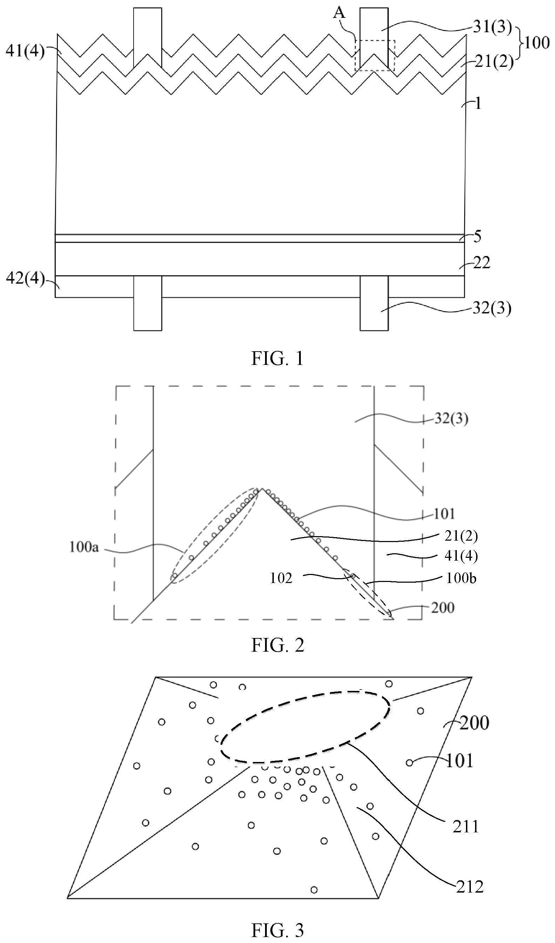

In a first aspect, referring to FIGS. 1 to 3, FIG. 1 shows a solar cell with a metal-semiconductor contact structure, FIG. 2 is an enlarged schematic view of a structure at A in FIG. 1, and FIG. 3 is a schematic diagram showing a distribution of first conductive microstructures on a pyramid structure. An embodiment of the present disclosure provides a metal-semiconductor contact structure, which is applied in a solar cell. The solar cell includes:
a silicon substrate 1;
a doped semiconductor layer 2 provided on the silicon substrate 1;
a metal electrode 3 in contact with the doped semiconductor layer 2.

Therein, mutual contact between the metal electrode 3 and the doped semiconductor layer 2 forms a metal-semiconductor contact structure 100. The mutual contact between the metal electrode 3 and the doped semiconductor layer 2 is physical contact, that is, the metal electrode 3 and the doped semiconductor layer 2 are in direct contact.

The metal-semiconductor contact structure 100 is described below.

The metal-semiconductor contact structure 100 includes:
the doped semiconductor layer 2, where a surface of the doped semiconductor layer 2 includes a surfaces of a pyramid structure 200;
a metal electrode 3 in contact with the doped semiconductor layer 2;
a first contact region 101a provided at a contact interface between the doped semiconductor layer 2 and the metal electrode 3, where a plurality of first conductive microstructures 101 are provided in the first contact region 101a.

The plurality of first conductive microstructures 101 are located at a contact interface between the metal electrode 3 and the doped semiconductor layer 2, and the plurality of first conductive microstructures 101 are disposed on a smooth surface of the pyramid structure 200. The first conductive microstructures 101 are eutectic particles composed of a metal element and a semiconductor element. The metal element is the same as a metal element in the metal electrode 3, and the semiconductor element is the same as a main semiconductor element in the doped semiconductor layer 2.

From an apex of a pyramid structure 200 toward a base of the pyramid structure 200, a distribution density of the first conductive microstructures 101 on the pyramid structure 200 exhibits a decreasing trend.

Therein, the surface of the doped semiconductor layer 2 including the surface of the plurality of pyramid structure 200 means that a shape of the surface of the doped semiconductor layer 2 is pyramid-shaped. A single pyramid structure 200 typically consists of an apex, side surfaces, and a base. A plurality of pyramid structures 200 together form the surface of the doped semiconductor layer 2, making the surface overall exhibit an uneven shape with a plurality of pyramids.

For solar cells, an originally flat surface of the silicon substrate 1 can be transformed into a pyramid-shaped surface by means of texturing and other processes and then a doped polysilicon layer is provided on the silicon substrate 1. The doped semiconductor layer 2 can be an additional film layer deposited on the silicon substrate 1, such as a boron-doped polysilicon layer formed on the silicon substrate 1 through deposition methods like Plasma-Enhanced Chemical Vapor Deposition (PECVD) as the doped semiconductor layer 2. In this case, the surface of the doped semiconductor layer 2 is a surface, facing away from the silicon substrate 1, of the doped semiconductor layer 2, which is conformal with the silicon substrate 1. Thus, the surface of the doped polysilicon layer has the same or similar pyramid shape as the surface of the silicon substrate 1. Alternatively, in other implementations, the doped semiconductor layer 2 can also be a diffusion layer formed by diffusing a semiconductor conductive element from the surface of the silicon substrate 1 into the silicon substrate 1, forming the diffusion layer of a certain thickness. For example, a high-temperature boron diffusion process is performed on the surface of the silicon substrate 1 to form a boron-doped diffusion layer, which functions as the doped semiconductor layer 2. In this case, the surface of the doped semiconductor layer 2 is actually the surface of the silicon substrate 1 that has been infused with the semiconductor conductive element. In this case, the surface of the silicon substrate 1 becomes the doped semiconductor layer 2 after diffusion. Since the surface of the silicon substrate 1 before diffusion is pyramid-shaped, after the silicon substrate 1 is diffused to form the doped semiconductor layer 2, the surface of the doped semiconductor layer 2 that is configured to be in contact with the metal electrode 3 is also pyramid-shaped.

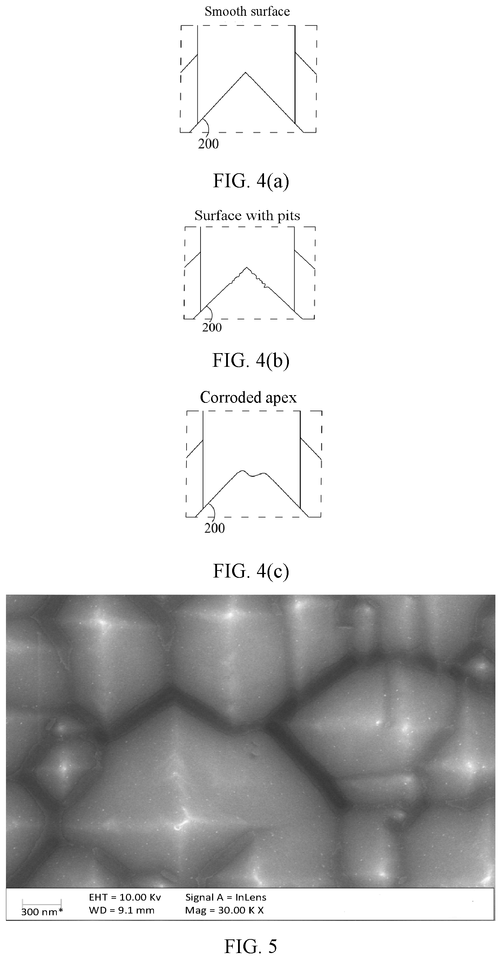

Therein, the first conductive microstructures 101 being disposed on the smooth surface of the pyramid structure 200 means that although the surface of the doped semiconductor layer 2 is composed of the plurality of pyramid structures 200 and overall exhibits the uneven shape with the plurality of pyramids, these pyramid structures 200 do not have significant structural damage such as holes or pits. This ensures that most or all areas of the surface of the doped semiconductor layer 2 (e.g., pyramid apexes and side surfaces) remain smooth and have a high degree of structural integrity. Referring to FIGS. 4(a)-4(c), FIGS. 4(a)-4(c) show schematic diagrams of the surface of the doped semiconductor layer 2 in different states. FIG. 4(a) a schematic diagram of a smooth surface of a doped semiconductor layer in a metal-semiconductor contact structure, which is also the structural characteristic of the surface of the doped semiconductor layer in the embodiments of the present disclosure. FIG. 4(b) is a schematic diagram of a doped semiconductor layer where large pits are formed on side surfaces of pyramids in a metal-semiconductor contact structure. FIG. 4(c) is a schematic diagram of a doped semiconductor layer where apexes of pyramids are corroded in a metal-semiconductor contact structure. FIGS. 4(b) and 4(c) illustrate the structural characteristics of the surface of the doped semiconductor layer 2 of metal-semiconductor contact structures 100 in related art.

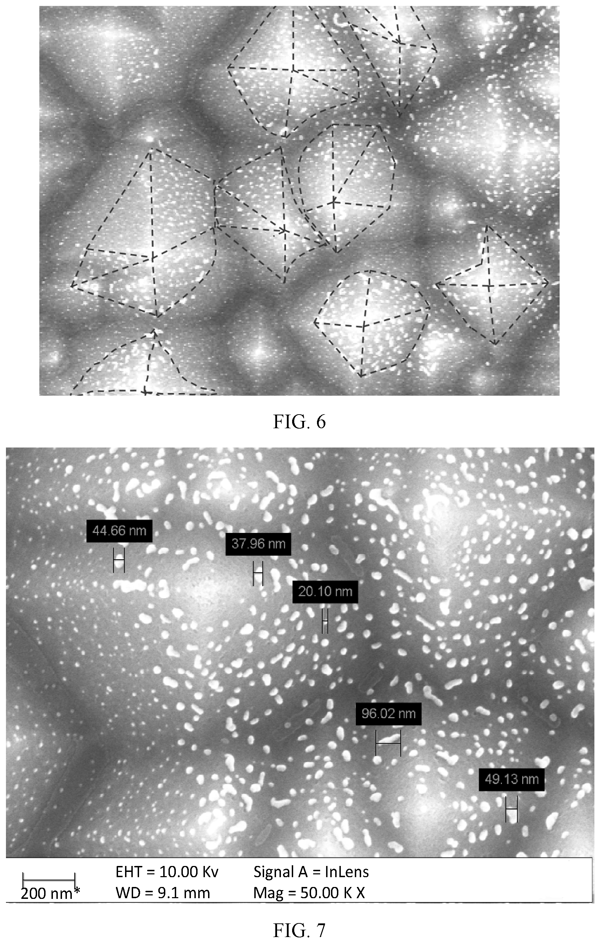

Using an untreated bare silicon substrate 1 as a comparative example, referring to FIG. 5, FIG. 5 shows an scanning electron microscope (SEM) image of an untreated bare silicon substrate. From this image, it can be seen that before treatments such as printing and sintering electrode paste, the surface of the silicon substrate 1 exhibits a pyramid shape, and the apexes and side surfaces of the pyramids maintain a high degree of integrity. Referring to FIGS. 6 and 7, FIGS. 6 and 7 show SEM images of a metal-semiconductor contact structure according to the embodiments of the present disclosure, with first conductive microstructures distributed on the doped semiconductor layer. Therein, the doped semiconductor layer 2 is obtained by diffusing a doped semiconductor conductive element into the silicon substrate 1, allowing comparison with the surface structure of the bare silicon substrate 1. Additionally, the magnification of FIG. 7 is different from FIG. 6. The magnification of FIG. 7 is 50K. Through comparison, it can be observed that in the embodiment of the present disclosure, although the first conductive microstructures 101 are disposed on the pyramid structures 200, they do not damage the smoothness of the surface of the doped semiconductor layer 2. Most areas of the surface maintain a good pyramid shape, with no significant holes or corrosion at the pyramid apexes and no large pits or damage on the pyramid side surfaces.

Therein, the first conductive microstructures 101 are eutectic particles composed of a metal element and a semiconductor element. The metal element of the first conductive microstructures 101 is the same as a metal element in the metal electrode 3, and the semiconductor element of the first conductive microstructures 101 is the same as a main semiconductor elements in the doped semiconductor layer 2. In other words, as an eutectic structure, the semiconductor element of the first conductive microstructures 101 is determined by the doped semiconductor layer 2, and the metal element is determined by the metal electrode 3. Additionally, the main semiconductor element in the doped semiconductor layer 2 refers to a semiconductor element that is the primary component of the doped semiconductor layer 2, not a doping element used to enhance the conductivity of the semiconductor layer.

Optionally, the metal element includes at least one of silver, lead, copper, aluminum, nickel, cadmium, or bismuth. Preferably, the metal electrode 3 is a silver electrode, and the metal element is silver. Optionally, the doped semiconductor layer 2 includes at least one of a doped amorphous silicon layer, a doped polysilicon layer, a doped microcrystalline silicon layer, or a doped monocrystalline silicon layer. Optionally, the doping element in the doped semiconductor layer 2 includes at least one of an N-type conductive element and a P-type conductive element. The N-type conductive element includes, for example, phosphorus, antimony, or arsenic, while the P-type conductive element includes, for example, boron, gallium, or indium. For example, if the metal electrode 3 is the silver electrode and the doped semiconductor layer 2 is the boron-doped polysilicon layer, then in the doped semiconductor layer 2, the main semiconductor element is silicon, the doping element is boron, and the first conductive microstructures 101 are silver-silicon eutectic structures formed through chemical bonding between silver and silicon.

Therein, from the apex of the pyramid structure 200 toward the base of the pyramid structure 200, a distribution density of the first conductive microstructures 101 on the pyramid structure 200 exhibits a decreasing trend. This indicates that in the embodiments of the present disclosure, the first conductive microstructures 101 are more concentrated in regions closer to the apex of the pyramid structure, while fewer first conductive microstructures 101 are distributed in regions closer to the base of the pyramid structure.

In the embodiments of the present disclosure, through the arrangement of the aforementioned metal-semiconductor contact structure 100, the ohmic contact performance at a pyramid-shaped contact interface between the doped semiconductor layer 2 and the metal electrode 3 may be comprehensively improved from two aspects: enhancing carrier transport capability and reducing recombination phenomena, thereby more effectively increasing the photoelectric conversion efficiency of the solar cells.

First, the metal-semiconductor contact structure 100 in the embodiments of the present disclosure features a more structurally stable carrier transport structure, which can effectively improve carrier transport capability. Compared to metal silver particles or silver elemental crystals simply attached to the pyramid structure 200, the eutectic particles in the embodiments of the present disclosure are formed through chemical bonding between the main semiconductor element in the doped semiconductor layer 2 and the metal element in the metal electrode 3, resulting in an eutectic structure. Therefore, the eutectic particles exhibit stronger adhesion and more reliable attachment to the pyramid structure 200, providing a more stable ohmic contact structure, enhancing the mechanical bonding strength at the metal-semiconductor contact interface, and thereby improving the carrier transport capability.

Second, the metal-semiconductor contact structure 100 in the embodiments of the present disclosure can mitigate recombination phenomena caused by defect damage as well as metal recombination phenomena. On one hand, although the first conductive microstructures 101 are formed on the pyramid structure 200, the pyramid structure 200 as a whole still maintains a smooth surface characteristic. There are no large-area corrosion pits formed on the pyramid side surfaces or near the apex of the pyramid, nor are there obvious hole damages formed at or near the apex of the pyramid. The pyramid structure 200 has high integrity and minimal damage, significantly reducing defect recombination issues caused by structural damage to the pyramid structure 200.

On the other hand, the first conductive microstructures 101 used in the embodiments of the present disclosure exhibit a unique distribution characteristic on the pyramid-shaped surface. That is, the first conductive microstructures 101 are more densely distributed near the apex of the pyramid and sparser near the base of the pyramid structure. Since most of the first conductive microstructures 101 are concentrated near the apex of the pyramid, a contact area between the pyramid side surfaces and the metal electrode 3 at this location is relatively small, resulting in less metal recombination. Although the contact area between the pyramid side surfaces and the metal electrode 3 increases in a direction toward the base of the pyramid structure, the distribution of the first conductive microstructures 101 in this region is relatively sparse, so there is also less metal recombination. Thus, the aforementioned distribution characteristic in the embodiments of the present disclosure ensures a sufficient quantity of first conductive microstructures 101 to enhance carrier transport capability while more effectively reducing metal recombination.

Furthermore, referring back to FIG. 6, at least part of the first conductive microstructures 101 exhibit a conical distribution on the pyramid structure 200. As shown in a dashed box area in FIG. 6, at least part of the first conductive microstructures 101 are concentrated near the apex of the pyramid, and these microstructures are distributed on all four pyramid side surfaces in this region. This structural arrangement further increases the quantity of first conductive microstructures 101 while reducing metal recombination.

Furthermore, referring back to FIG. 7, a plurality of first conductive microstructures 101 are spaced apart and dispersed on the surface of the pyramid structure 200. In other words, the first conductive microstructures 101 in the embodiments of the present disclosure are highly dispersed without significant agglomeration into large-sized particles. This facilitates the provision of more effective carrier transport pathways, reduces the contact resistance of the metal-semiconductor contact structure 100, and enhances the mechanical structural stability of the metal-semiconductor contact interface.

Furthermore, a particle size of the eutectic particles ranges from 10 nm to 200 nm. For example, the particle size of the eutectic particles can be 10 nm, 20 nm, 50 nm, 80 nm, 100 nm, 120 nm, 150 nm, 180 nm, or 200 nm.

Furthermore, in any 10 µm × 10 µm region of the first contact region 100a, a quantity of the eutectic particles ranges from 100 to 1500. For example, in any 10 µm × 10 µm region of the first contact region 100a, the quantity of eutectic particles can be 100, 200, 500, 600, 800, or 1000. When the particle size and the quantity of the eutectic particles fall within the above ranges, it is beneficial to better prevent agglomeration of the first conductive microstructures 101, thereby further reducing contact resistance and improving fill factors.

Furthermore, a side length of the base of the pyramid structure 200 ranges from 0.35 µm to 2.5 µm, and a diagonal length of the base of the pyramid structure 200 ranges from 0.5 µm to 3.5 µm. When the side length and the diagonal length of the base of the pyramid structure 200 fall within the above ranges, it indicates that an overall size of the pyramid structure 200 in the embodiments of the present disclosure is relatively small, belonging to small-sized base of the pyramid structure. On such small-sized base of the pyramid structure, the first conductive microstructures 101 are mainly distributed in a conical shape near the apex of the pyramid, indicating that there are no large-area continuous clustered conductive structures (e.g., large-area continuous silver blocks or silver spots) in contact with the pyramid structure 200 of the doped semiconductor layer 2. This structural arrangement helps reduce metal recombination in the metal-semiconductor contact structure 100 and increase an open circuit voltage.

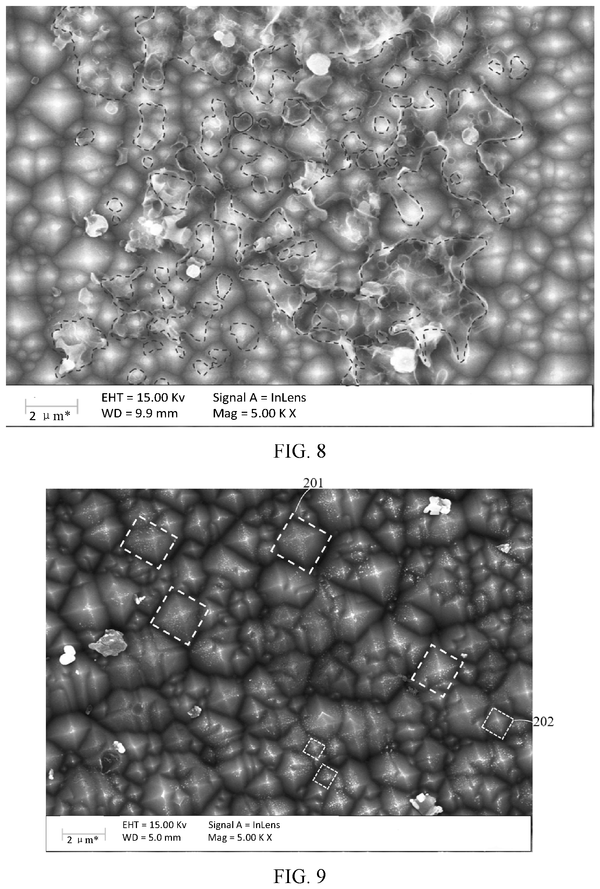

Furthermore, referring to FIG. 9, the pyramid structure 200 includes a plurality of first-type pyramid structures 201 and a plurality of second-type pyramid structures 202 distributed among the first-type pyramid structures 201. A diagonal length of the base of the first-type pyramid structure 201 ranges from 1.5 µm to 3.5 µm, and a diagonal length of the base of the second-type pyramid structure 202 ranges from 0.5 µm to 1.5 µm. Based on the overall small-size characteristic of the pyramid structure 200, the first-type pyramid structures 201 have relatively larger sizes, and the second-type pyramid structures 202 have relatively smaller sizes. Distributing the second-type pyramid structures 202 among the first-type pyramid structures 201 allows for more efficient utilization of the space near the base regions of the first-type pyramid structures 201, providing more uneven surface structures and increasing an area of surfaces of the pyramid structures 200. This structural arrangement, on one hand, improves light utilization efficiency, and on the other hand, provides more area near the apex of the pyramid and the adjacent pyramid side surfaces for the attachment of more first conductive microstructures 101, further enhancing carrier transport capability and the mechanical bonding strength of the metal-semiconductor contact interface.

Furthermore, as shown in FIG. 3, the first conductive microstructures 101 are distributed in a first distribution region 211 and a second distribution region 212 on the surface of the first-type pyramid structure 201. In the first distribution region 211, a distribution density of the first conductive microstructures 101 ranges from 100 particles/µm² to 400 particles/µm². In the second distribution region 212, a distribution density of the first conductive microstructures 101 ranges from 20 particles/µm² to 100 particles/µm², and the distribution of the first conductive microstructures 101 is denser in the first distribution region than in the second distribution region. Therein, a lateral side length of the pyramid structure 200 is L, and a region with a radius less than or equal to R centered on the apex of the pyramid structure 200 is the first distribution region. A region of the surface of the pyramid structure 200 outside the first distribution region 211 is the second distribution region 212, where R/L ≤ 2:3.

A distribution density of the first conductive microstructures 101 on the surface of the second-type pyramid structure 202 ranges from 30 particles/µm² to 100 particles/µm².

By controlling the distribution density of the first conductive microstructures 101 on the surfaces of the first-type pyramid structures 201 and the second-type pyramid structures 202 within the above ranges, the quantity of first conductive microstructures 101 is sufficient, so that their adhesion to the pyramid structure 200 is stronger, and their contact area with the metal electrode 3 is relatively small. This is beneficial for better improving carrier transport capability while significantly reducing metal recombination.

Referring to FIG. 2, in addition to the first contact region 100a, a second contact region 100b is further provided at the contact interface between the contact region between the doped semiconductor layer 2 and the metal electrode 3. The second contact region 100b is located at an edge of the first contact region 100a and a plurality of second conductive microstructures 102 are provided in the second contact region 100b. The second conductive microstructures 102 are embedded in the glass phase of the metal electrode 3 and are metal elemental particles. The metal elemental particles are composed of the same metal element as the metal electrode 3. For example, if the metal electrode 3 is a silver electrode, then the second conductive microstructures 102 are silver elemental particles.

Furthermore, in a preset region of the contact interface, an area ratio of the second contact region 100b to the preset region ranges from 1:5 to 1:3. Therein, the preset region is defined as any preset width × preset length region centered on a center line of a width of the metal electrode 3. The preset width is perpendicular to a width direction of the metal electrode 3 and is less than or equal to 23 µm. The preset length is parallel to the width direction of the metal electrode 3 and is less than or equal to 16 µm. When the area ratio of the second contact region 100b (i.e., the region containing metal elemental particles) to the preset region falls within the above range, it means that the first contact region 100a (i.e., a region containing the eutectic particles) occupies a larger proportion of the preset region, which is beneficial for more effectively improving contact performance and reducing recombination issues.

In the embodiments of the present disclosure, the metal electrode 3 refers to an electrode configured to be in contact with the doped semiconductor layer 2. For example, when a current-collecting electrode is in direct contact with the doped semiconductor layer and a bus bar electrode is not in direct contact with the doped semiconductor layer, only the current-collecting electrode and the doped semiconductor layer have a contact region. In this case, the metal electrode 3 refers to a finger electrode.

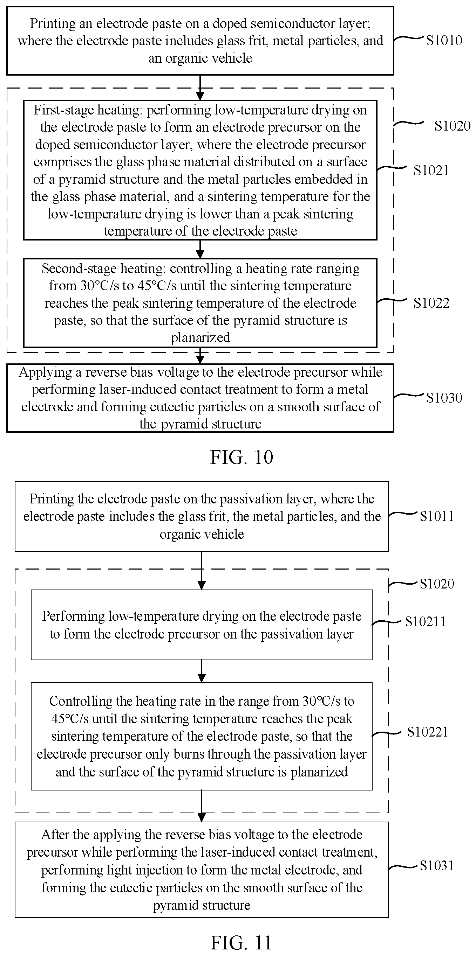

The embodiments of the present disclosure further provide a manufacturing method for the aforementioned metal-semiconductor contact structure. As shown in FIG. 10, the method includes the following steps.

Step S1010: printing an electrode paste on a doped semiconductor layer; where the electrode paste includes a glass phase material, metal particles, and an organic vehicle;
Step S1020: performing staged sintering, including:
Step S1021 first-stage heating: performing low-temperature drying on the electrode paste to form an electrode precursor on the doped semiconductor layer, where the electrode precursor comprises the glass phase material distributed on a surface of a pyramid structure and the metal particles embedded in the glass phase material, and a sintering temperature for the low-temperature drying is lower than a peak sintering temperature of the electrode paste.

Step S1022: second-stage heating: controlling a heating rate in a range from 30°C/s to 45°C/s until the sintering temperature reaches the peak sintering temperature of the electrode paste, so that the surface of the pyramid structure is planarized.

Step S1030: applying a reverse bias voltage to the electrode precursor while performing laser-induced contact treatment to form a metal electrode and forming eutectic particles on a smooth surface of the pyramid structure.

In the above manufacturing method, after printing the electrode paste, staged drying and sintering of the electrode paste are performed, and the heating rate during the second-stage heating is controlled to ensure that the pyramid structure remains relatively smooth and maintains high structural integrity after sintering treatment, without damage to the apex of the pyramid or side surfaces from glass phase etching. Then, by applying the reverse bias voltage and the laser-induced contact treatment, the main semiconductor element in the doped semiconductor layer and the metal element in the metal electrode form the eutectic particles through chemical bonding, resulting in a metal-semiconductor contact structure with better contact performance and stronger mechanical bonding capability at the metal-semiconductor contact interface.

Furthermore, a passivation layer is provided on the doped semiconductor layer. As shown in FIG. 11, step S1010 includes the following sub-steps.

Step S1011: printing the electrode paste on the passivation layer, where the electrode paste includes the glass phase material, the metal particles, and the organic vehicle;
In the first-stage heating step, step S1021 includes the following sub-steps.

Step S10211: performing low-temperature drying on the electrode paste to form the electrode precursor on the passivation layer;
In the second-stage heating step, step S1022 includes the following sub-steps.

Step S10221: controlling the heating rate in the range from 30°C/s to 45°C/s until the sintering temperature reaches the peak sintering temperature of the electrode paste, so that the electrode precursor only burns through the passivation layer and the surface of the pyramid structure is planarized;
In the manufacturing method, step S1030 includes the following sub-steps.

Step S1031: after the applying the reverse bias voltage to the electrode precursor while performing the laser-induced contact treatment, performing light injection to form the metal electrode, and forming the eutectic particles on the smooth surface of the pyramid structure.

By controlling the heating rate during the second-stage heating, an etching rate of the glass phase material on the passivation layer can be better controlled, avoiding severe corrosion of the pyramid structure of the doped semiconductor layer by the glass phase.

Furthermore, conditions for the first-stage heating include: a heating temperature ranging from 250°C to 350°C and a heating time ranging from 5 s to 20 s.

Furthermore, conditions for the second-stage heating include: a heating temperature ranging from 700°C to 800°C and a heating time ranging from 10 s to 20 s.

The above manufacturing process for the solar cell is only one optional implementation. The metal-semiconductor contact structure in the embodiments of the present disclosure can also be obtained through other process technologies in the field, which is not limited in the present disclosure.

Additionally, the metal-semiconductor contact structure in the embodiments of the present disclosure can be applied to various types of solar cells. Optionally, the solar cell includes a Passivated Emitter and Rear Cell (PERC), a Heterojunction Technology (HJT) cells, Tunnel Oxide Passivated Contact (TOPCon) cells, Interdigitated Back Contact (IBC) cells, or perovskite-crystalline silicon tandem solar cells.

Referring back to FIG. 1, FIG. 1 shows a solar cell suitable for the metal-semiconductor contact structure 100. The solar cell specifically includes:
a silicon substrate 1;
a first doped semiconductor layer 21, a first passivation layer 41, and a first metal electrode 31 successively provided on a light-receiving surface of the silicon substrate 1 along a direction away from the light-receiving surface of the silicon substrate 1, the first doped semiconductor layer 21 having a conductivity type opposite to a conductivity type of the silicon substrate 1, where the first metal electrode 31 passes through the first passivation layer 41 and is in contact with the first doped semiconductor layer 21, forming the metal-semiconductor contact structure 100 between the first doped semiconductor layer 21 and the first metal electrode 31;
a passivated contact structure, a second passivation layer 42, and a second metal electrode 32 successively provided on a back light surface of the silicon substrate 1 along a direction away from the back light surface of the silicon substrate 1, where the passivated contact structure includes a dielectric layer 5 disposed adjacent to the silicon substrate 1 and a second doped semiconductor layer 22 disposed on a side, away from the silicon substrate 1, of the dielectric layer 5, the second doped semiconductor layer 22 has the same conductivity type as the silicon substrate 1, and the second metal electrode 32 passes through the second passivation layer 42 and is in an ohmic contact with the second doped semiconductor layer 22.

Optionally, the first doped semiconductor layer 21 is formed by thermal diffusion of a doping element into the silicon substrate 1, or the first doped semiconductor layer 21 is a doped polysilicon layer or a doped amorphous silicon layer deposited on the light-receiving surface of the silicon substrate 1. Optionally, the first passivation layer 41 includes one or more layers of any combination of an aluminum oxide layer, a silicon oxide layer, a silicon oxynitride layer, and a silicon nitride layer deposited on a PN junction region. Optionally, the dielectric layer 5 includes at least one of a silicon oxide layer, an amorphous silicon layer, a polycrystalline silicon layer, or a silicon carbide layer. Optionally, the second passivation layer 42 includes one or more layers of any combination of the silicon oxide layer, the silicon oxynitride layer, and the silicon nitride layer deposited on the second doped semiconductor layer deposited on the second doped semiconductor layer 22.

Since the light-receiving surface of the silicon substrate 1 in FIG. 1 is pyramid-shaped, the metal-semiconductor contact structure 100 formed between the first doped semiconductor layer 21 on the light-receiving side and the first metal electrode 31 features first conductive microstructures with a specific distribution density trend on the pyramid structure. In contrast, the back light surface of the silicon substrate 1 in FIG. 1 is planar. Therefore, although the second metal electrode 32 is also in an ohmic contact with the second doped semiconductor layer 22, they do not form a metal-semiconductor contact structure with the same conductive microstructure characteristics as the light-receiving surface.

In a second aspect, the embodiments of the present disclosure provide a photovoltaic module, including the solar cell described in the first aspect, where plurality of solar cells are connected in series and/or in parallel to form a solar cell string; and
a packaging structure, where the solar cell string is packaged in the packaging structure.

The following further illustrates the present disclosure with more specific embodiments.

### Embodiment 1

This embodiment provides a solar cell with a metal-semiconductor contact structure, including:
an N-type silicon substrate, where a light-receiving surface of the N-type silicon substrate is a pyramid-shaped surface;
a boron diffusion layer, an aluminum oxide passivation layer, a silicon nitride antireflection layer, and a first metal electrode successively provided on the light-receiving surface of the N-type silicon substrate; where the first metal electrode passes through the silicon nitride antireflection layer and the aluminum oxide passivation layer, and is in contact with the boron diffusion layer, forming a metal-semiconductor contact structure between the first metal electrode and the boron diffusion layer; and
a silicon oxide dielectric layer, a phosphorus-doped polysilicon layer, a silicon nitride passivation layer, and a second metal electrode successively provided on a back light surface of the N-type silicon substrate, where the second metal electrode passes through the silicon nitride passivation layer and is in an ohmic contact with the phosphorus-doped polysilicon layer.

Therein, the boron diffusion layer has a surface in contact with the first metal electrode. Since the boron diffusion layer is obtained by boron diffusion into the N-type silicon substrate, the surface of the boron diffusion layer has surfaces of pyramid structures. In the metal-semiconductor contact structure formed by the mutual contact between the boron diffusion layer and the first metal electrode, a contact interface between the boron diffusion layer and the first metal electrode includes a first contact region and a second contact region located at an edge of the first contact region. The first contact region is provided with a plurality of first conductive microstructures, and the second contact region is provided with a plurality of second conductive microstructures.

The first conductive microstructures are located between the first metal electrode and the pyramid structure and are arranged on smooth surfaces of the pyramid structure. Therein, the first metal electrode is a silver electrode, and the first conductive microstructures are eutectic particles composed of silver and silicon elements. From the apex of the pyramid structure toward the base of the pyramid structure, a distribution density of the conductive microstructures on the pyramid structure decreases.

The second conductive microstructures are embedded in the glass phase of the second metal electrode, and the second conductive microstructures are silver elemental particles.

Scanning electron microscopy (SEM) test was performed on the metal-semiconductor contact structure described above, and the SEM images are shown in FIGS. 6 to 8. The scanning electron microscopy test method for the metal-semiconductor contact structure is described below.

A chemical etching method is used, including: first heating a nitric acid solution with a mass fraction of 50% to 80% to 60°C to 85°C, then immersing the solar cell in the above-mentioned nitric acid solution for 3 to 10 minutes, and removing the metal electrode. Afterward, SEM is used to capture images, resulting in the SEM image shown in FIG. 8. From this image, the distribution region of the glass phase under the electrode can be observed. A region circled by the dashed line in FIG. 8 roughly represents a distribution range of the glass phase, which contains elemental silver particles.

Then, deionized water or distilled water is used to flush out the residual liquid medicine. Then the cleaned solar cell is immersed in a hydrofluoric acid solution with a mass fraction of 1% to 10% and soaked for 2 to 5 minutes to remove the residual glass phase material. Finally, the deionized water or the distilled water is used to flush out the residual liquid and corrosion is completed. SEM was used to capture images at different magnifications to obtain the SEM images shown in FIG. 6 and FIG. 7. From these images, the distribution of the first conductive microstructures on the surface of the doped semiconductor layer (i.e., the surface of the pyramid structure) can be observed. The concentration of the acid agent, etching temperature, and time used in the aforementioned etching method can be adaptively adjusted based on the removal effect, as long as the removal of the metal electrode and the glass phase material is achieved. For example, when the concentration of the acid agent is increased and/or the temperature conditions are elevated, the etching time can be appropriately shortened to achieve better removal of the metal electrode and glass phase material.

Referring to FIGS. 6 to 7, it can be seen that in the metal-semiconductor contact structure on the light-receiving surface, the pyramid structure of the boron diffusion layer (the surface of the silicon substrate before boron diffusion) exhibits high surface integrity and relatively flat structural characteristics. There is no significant large-area corrosion at the apex of the pyramid or the presence of numerous pores, nor are there large quantity of pits or pit islands on the pyramid side surfaces. This indicates that the surface of the pyramid structure of the doped semiconductor layer in the embodiments of the present disclosure maintains a high degree of structural integrity.

Among them, a particle size of the eutectic particles ranges from 10 nm to 200 nm. In any 10 µm × 10 µm region of the first contact region, a quantity of the eutectic particles ranges from 100 to 1500. The first conductive microstructures are spaced apart and dispersedly distributed on the pyramid structure, primarily exhibiting a conical distribution in the region near the apex of the pyramid. A side length of the base of the pyramid structure ranges from 0.35 µm to 2.5 µm; and a diagonal length of the base of the pyramid structure ranges from 0.5 µm to 3.5 µm.

### Embodiment 2

This embodiment provides a solar cell. A main difference between this embodiment and the aforementioned Embodiment 1 lies in the distribution of the first conductive microstructures on the pyramid structure.

Therein, the pyramid structure includes a plurality of first-type pyramid structures and a plurality of second-type pyramid structures distributed among the first-type pyramid structures. A diagonal length of a base of a first-type pyramid structure ranges from 1.5 µm to 3.5 µm, and a diagonal length of a base of a second-type pyramid structures ranges from 0.5 µm to 1.5 µm.

The first conductive microstructures are distributed in a first distribution region and a second distribution region on the surface of the first-type pyramid structure. In the first distribution region, a distribution density of the first conductive microstructures ranges from 100 per µm² to 400 per µm². In the second distribution region, a distribution density of the first conductive microstructures ranges from 20 per µm² to 100 per µm². The distribution of the first conductive microstructures is denser in the first distribution region than in the second distribution region. Therein, a side length of the pyramid structure is L. Taking the apex of the pyramid structure as a center, a region with a radius less than or equal to R is the first distribution region, and a region of the surface of the pyramid structure outside the first distribution region is the second distribution region, where R/L = 2:3.

A distribution density of the first conductive microstructures on the surface of the second-type pyramid structure ranges from 30 per µm² to 100 per µm². Referring to FIG. 9, FIG. 9 is an SEM image of the doped semiconductor layer with the first conductive microstructures distributed in the metal-semiconductor contact structure of the present embodiment, illustrating the distribution of the first conductive microstructures on the pyramid structure.

Description of performance testing:
Open circuit voltage, fill factor, and photoelectric conversion efficiency test:
The open circuit voltage, filling factor, photoelectric conversion efficiency and other performance tests were carried out using a halm test and separation equipment. The halm machine was a solar simulator equipped with electronic load, data acquisition and calculation equipment to test the electrical performance of photovoltaic devices (including solar cells). The silicon wafer of the tested solar cell was controlled to size 182 and the calibrated light intensity was 1000±5 W/m².

Contact resistance test: a contact resistivity tester (e.g. TLM-STD of American Photovoltaic) was used for the contact resistance performance test, and the characteristic impedance of the transmission line is determined by measuring the current and voltage, and then the value of the contact resistance was derived by a calculation formula according to the characteristic impedance. The width of the test specimen was 6 mm.

**Table 1 Performance Test Results of Each Embodiment**

| | Photoelectric conversion efficiency Eta (%) | Open circuit voltage V_{oc} (V) | Filling factor FF (%) | Normalized series resistance Rs (Ω·cm²) |
|---|---|---|---|---|
| Embodiment 1 | 26.35 | 0.7338 | 85.47 | 0.02 |
| Embodiment 2 | 26.85 | 0.7391 | 86.19 | 0.01 |

It can be seen from the test results in Table 1 that in the solar cells of Embodiment 1 and Embodiment 2 of the present disclosure, a normalized series resistance ranges from 0.01 Ω·cm² to 0.02 Ω·cm², and the photoelectric conversion efficiency reaches above 26.35%. Compared to similar solar cells which generally have a photoelectric conversion efficiency of less than 25%, this represents a significant improvement. Thus, the solar cells of Embodiment 1 and Embodiment 2 of the present disclosure both exhibit excellent series resistance performance and high photoelectric conversion efficiency. In particular, the open circuit voltage, fill factor, and series resistance performance of Embodiment 2 are superior to those of Embodiment 1, indicating that the combination of first-type and second-type pyramid structures and the distribution of the first conductive microstructures on these pyramid structures contribute to further enhancing the photoelectric conversion efficiency of the solar cell.

The technical solutions disclosed in the embodiments of the present disclosure have been described in detail above. Specific examples were used in this document to explain the principles and implementation methods of the present disclosure. The descriptions of the above embodiments are only intended to help understand the technical solutions and core inventive points of the embodiments of the present disclosure. At the same time, for those of ordinary skill in the art, based on the ideas of the present disclosure, there will be changes in specific implementation methods and present disclosure scopes. In summary, the content of this specification should not be construed as limiting the present disclosure.

## Claims

1. A metal-semiconductor contact structure, comprising:
a doped semiconductor layer (2), a surface of the doped semiconductor layer (2) comprising a surface of at least one pyramid structure (200);
a metal electrode (3) in contact with the doped semiconductor layer (2); and
a first contact region (100a) provided at a contact interface between the doped semiconductor layer (2) and the metal electrode (3), a plurality of first conductive microstructures (101) being provided in the first contact region (100a);
wherein the plurality of first conductive microstructures (101) are disposed between the metal electrode (3) and the pyramid structure (200), and are disposed on a smooth surface of the pyramid structure (200); particles forming the plurality of first conductive microstructures (101) are eutectic particles composed of a metal element and a semiconductor element, the metal element is the same as a metal element in the metal electrode (3), and the semiconductor element is the same as a main semiconductor element in the doped semiconductor layer (2);
from an apex of the pyramid structure (200) toward a base of the pyramid structure (200), a distribution density of the plurality of first conductive microstructures (101) on the pyramid structure (200) exhibits a decreasing trend.

2. The metal-semiconductor contact structure according to claim 1, wherein a particle size of the eutectic particles ranges from 10 nm to 200 nm; and/or,
a quantity of the eutectic particles ranges from 100 to 1500 in any 10 µm×10 µm region of the first contact region (100a); and/or,
the plurality of first conductive microstructures (101) are spaced apart and dispersed on the surface of the pyramid structure (200); and/or,
at least part of the plurality of first conductive microstructures (101) are distributed in a conical shape on the pyramid structure (200).

3. The metal-semiconductor contact structure according to claim 1 or 2, wherein a side length of the base of the pyramid structure (200) ranges from 0.35 µm to 2.5 µm; and/or,
a diagonal length of the base of the pyramid structure (200) ranges from 0.5 µm to 3.5 µm.

4. The metal-semiconductor contact structure according to claim 3, wherein the at least one pyramid structure (200) comprises: a plurality of first-type pyramid structures (201) and a plurality of second-type pyramid structures (202) distributed among the plurality of first-type pyramid structures (201);
a diagonal length of a base of each of the plurality of first-type pyramid structures (201) ranges from 1.5 µm to 3.5 µm, and a diagonal length of a base of each of the plurality of the second-type pyramid structures (202) ranges from 0.5 µm to 1.5 µm.

5. The metal-semiconductor contact structure according to claim 4, wherein the plurality of first conductive microstructures (101) are distributed in a first distribution region (211) and a second distribution region (212) on a surface of each of the plurality of first-type pyramid structures (201); in the first distribution region (211), a distribution density of the first conductive microstructures (101) ranges from 100 pcs/µm² to 400 pcs/µm², and in the second distribution region (212), a distribution density of the first conductive microstructures (101) ranges from 20 pcs/µm² to 100 pcs/µm², and the distribution of the first conductive microstructures (101) is denser in the first distribution region (211) than in the second distribution region (212);
wherein a lateral side length of the pyramid structure (200) is L, a region of the surface of the pyramid structure (200) with a radius less than or equal to R centered on the apex of the pyramid structure (200) is the first distribution region, a region of the surface of the pyramid structure (200) outside the first distribution region (211) is the second distribution region (212), and R/L ≤ 2:3; and
the distribution density of the first conductive microstructures (101) on a surface of each of the plurality of second-type pyramid structures (202) ranges from 30 pcs/µm² to 100 pcs/µm²

6. The metal-semiconductor contact structure according to any one of claims 1 to 5, wherein a second contact region (100b) is further provided at the contact interface between the doped semiconductor layer (2) and the metal electrode (3), the second contact region (100b) is located at an edge of the first contact region (100a), and a plurality of second conductive microstructures (102) are provided in the second contact region (100b); and
the second conductive microstructures (102) are metal elemental particles embedded in a glass phase of the metal electrode (3), and a metal element of the metal elemental particles is the same as the metal element in the metal electrode (3).

7. The metal-semiconductor contact structure according to claim 6, wherein in a preset region of the contact interface, an area ratio of the second contact region (101b) to the preset region ranges from 1:5 to 1:3, the preset region is an area of any preset width × preset length, centered on a center line of a width of the metal electrode, the preset width is perpendicular to a width direction of the metal electrode, the preset width is less than or equal to 23 µm, the preset length is parallel to the width direction of the metal electrode, and the preset length is less than or equal to 16 µm.

8. The metal-semiconductor contact structure according to any one of claims 1 to 7, wherein the doped semiconductor layer (2) comprises at least one of a doped amorphous silicon layer, a doped polycrystalline silicon layer, a doped microcrystalline silicon layer, and a doped crystalline silicon layer; and/or
a doping element in the doped semiconductor layer (2) comprises at least one of an N-type conductive element or a P-type conductive element; and/or
the metal element comprises at least one of silver, lead, copper, aluminum, nickel, cadmium, or bismuth.

9. A solar cell, comprising a silicon substrate and a metal-semiconductor contact structure (100) located on the silicon substrate (1), wherein the metal-semiconductor contact structure (100) comprises:
a doped semiconductor layer (2), disposed on a surface of the silicon substrate (1), a surface, facing away from the silicon substrate (1), of the doped semiconductor layer (2) comprising a surface of at least one pyramid structure (200);
a metal electrode (3), located on a side, facing away from the silicon substrate (1), of the doped semiconductor layer (2), and in contact with the doped semiconductor layer (2); and
a first contact region (101a) provided at a contact interface between the doped semiconductor layer (2) and the metal electrode (3), and a plurality of first conductive microstructures (101) being provided in the first contact region (101a);
wherein the plurality of first conductive microstructures (101) are disposed between the metal electrode (3) and the pyramid structure (200), and are disposed on a smooth surface of the pyramid structure (200); particles forming the plurality of first conductive microstructures (101) are eutectic particles composed of a metal element and a semiconductor element, the metal element is the same as a metal element in the metal electrode (3), and the semiconductor element is the same as a main semiconductor element in the doped semiconductor layer (2);
from an apex of the pyramid structure (200) toward a base of the pyramid structure (200), a distribution density of the plurality of first conductive microstructures (101) on the pyramid structure (200) exhibits a decreasing trend.

10. The solar cell according to claim 9, wherein the solar cell comprises:
a first doped semiconductor layer (21), a first passivation layer (41), and a first metal electrode (31) successively provided on a light-receiving surface of the silicon substrate (1) along a direction away from the light-receiving surface of the silicon substrate (1), the first doped semiconductor layer (21) having a conductivity type opposite to a conductivity type of the silicon substrate (1), wherein the first metal electrode (31) passed through the first passivation layer (41) and is in contact with the first doped semiconductor layer (21), forming the metal-semiconductor contact structure (100) between the first doped semiconductor layer (21) and the first metal electrode (31); and
a passivation contact structure, a second passivation layer (42), and a second metal electrode (32) successively provided on a back light surface of the silicon substrate (1) along a direction away from the back light surface of the silicon substrate (1), wherein the passivation contact structure comprises a dielectric layer (5) disposed adjacent to the silicon substrate (1) and a second doped semiconductor layer (22) disposed on a side, away from the silicon substrate (1), of the dielectric layer (5), the second doped semiconductor layer (22) has a same conductivity type as the conductivity type of the silicon substrate (1), and the second metal electrode (32) passes through the second passivation layer (42) and is in an ohmic contact with the second doped semiconductor layer (22).

11. The solar cell according to claim 10, wherein the first doped semiconductor layer (21) is formed by thermal diffusion of a doping element into the silicon substrate (1), or the first doped semiconductor layer (21) is a doped polycrystalline silicon layer or a doped amorphous silicon layer deposited on the light-receiving surface of the silicon substrate; and/or
the first passivation layer (5) comprises one or more layers of any combination of an aluminum oxide layer, a silicon oxide layer, a silicon oxynitride layer, and a silicon nitride layer deposited on a PN junction region; and/or
the dielectric layer (41) comprises at least one of a silicon oxide layer, an amorphous silicon layer, a polycrystalline silicon layer, or a silicon carbide layer; and/or
the second passivation layer (42) comprises one or more layers of any combination of the silicon oxide layer, the silicon oxynitride layer, and the silicon nitride layer deposited on the second doped semiconductor layer (22).

12. A photovoltaic module, comprising the solar cell according to any one of claims 9 to 11, a plurality of solar cells being connected in series and/or in parallel to form a solar cell string; and
a packaging structure, wherein the solar cell string is packaged in the packaging structure.

13. A manufacturing method for a metal-semiconductor contact structure, comprising:
printing (S1010) an electrode paste on a doped semiconductor layer (2); wherein the electrode paste comprises a glass phase material, metal particles, and an organic carrier;
performing staged sintering (S1020):
first-stage heating (S1021): performing low-temperature drying on the electrode paste to form an electrode precursor on the doped semiconductor layer (2), wherein the electrode precursor comprises the glass phase material distributed on a surface of a pyramid structure (200) and the metal particles embedded in the glass phase material, and a sintering temperature for the low-temperature drying is lower than a peak sintering temperature of the electrode paste;
second-stage heating (S1022): controlling a heating rate in a range from 30°C/s to 45°C/s until the sintering temperature reaches the peak sintering temperature of the electrode paste, so that the surface of the pyramid structure (200) is planarized; and
applying (S1030) a reverse bias voltage to the electrode precursor while performing laser-induced contact treatment to form a metal electrode (3) and forming eutectic particles on a smooth surface of the pyramid structure (200);
wherein conditions for the first-stage heating (S1021) comprise: a heating temperature ranging from 250°C to 350°C and a heating time ranging from 5 s to 20 s;
conditions for the second-stage heating (S1022) comprise: a heating temperature ranging from 700°C to 800°C and a heating time ranging from 10 s to 20 s.

14. The manufacturing method for the metal-semiconductor contact structure according to claim 13, wherein a passivation layer (5) is provided on the doped semiconductor layer (2), and the printing (S1010) the electrode paste on the doped semiconductor layer (2) comprises: printing (S1031) the electrode paste on the passivation layer (5);
in the step of first-stage heating (S1021), the performing low-temperature drying on the electrode paste to form the electrode precursor on the doped semiconductor layer (2) comprises: performing low-temperature drying (S10211) on the electrode paste to form the electrode precursor on the passivation layer (5);
in the step of second-stage heating (S1022), the controlling the heating rate in the range from 30°C/s to 45°C/s until the sintering temperature reaches the peak sintering temperature of the electrode paste comprises: controlling (S10221) the heating rate in the range from 30°C/s to 45°C/s until the sintering temperature reaches the peak sintering temperature of the electrode paste, so that the electrode precursor only burns through the passivation layer (5) and the surface of the pyramid structure (200) is planarized.

15. The manufacturing method for the metal-semiconductor contact structure according to claim 14, wherein the applying (S1030) the reverse bias voltage to the electrode precursor while performing the laser-induced contact treatment to form the metal electrode (3) and forming the eutectic particles on the smooth surface of the pyramid structure (200) comprises:
after the applying (S1031) the reverse bias voltage to the electrode precursor while performing the laser-induced contact treatment, performing light injection to form the metal electrode (3), and forming the eutectic particles on the smooth surface of the pyramid structure (200).
